# EUROPEAN PATENT APPLICATION

(11) **EP 4 465 793 A1**
(43) Date of publication of application: **20.11.2024**
(21) Application number: 24166179.2
(22) Date of filing: 26.03.2024
(51) Int. Cl.: H10K 59/122, H10K 59/80

(54) **DISPLAY DEVICE**

(30) Priority: 16.05.2023 KR 20230063012; 31.05.2023 KR 20230070160
(71) Applicant: Samsung Display Co., Ltd., Yongin-si, Gyeonggi-do 17113 (KR)
(72) Inventor: Kim, Swae Hyun, Giheung-gu, Yongin-si, Gyeonggi-do 17113 (KR); Kim, Deok Hoi, Giheung-gu, Yongin-si, Gyeonggi-do 17113 (KR); Seon, Jong Baek, Giheung-gu, Yongin-si, Gyeonggi-do 17113 (KR); Lhee, Za Il, Giheung-gu, Yongin-si, Gyeonggi-do 17113 (KR); Lee, Jeong Ho, Giheung-gu, Yongin-si, Gyeonggi-do 17113 (KR); Jang, Hye Jin, Giheung-gu, Yongin-si, Gyeonggi-do 17113 (KR)
(74) Representative: Dr. Weitzel & Partner

(57) **Abstract**

A display device includes: a first display area comprising a plurality of emission areas configured to emit light; and a second display area adjacent to the first display area, wherein the second display area includes: a plurality of emission areas; a transmission portion configured to transmit light; a thin film transistor on a substrate; a pixel defining layer on the thin film transistor to define the plurality of emission areas and including a flat portion having a flat upper surface and a tapered portion having an upper surface inclined from the upper surface of the flat portion; and a pixel electrode on the thin film transistor to be exposed by the pixel defining layer and completely overlapping the tapered portion.

## Description

### BACKGROUND

### 1. Field

The present invention relates to a display device.

### 2. Description of Related Art

With the advance of information-oriented society, more and more demands are placed on display devices for displaying images in various ways. For example, display devices are employed in various electronic devices such as smartphones, digital cameras, laptop computers, navigation devices, and smart televisions. In the display device, since each of pixels of a display panel includes a light emitting element capable of emitting light by itself, an image can be displayed without a backlight unit providing light to the display panel.

The display device may include a display panel displaying an image, a camera, and a sensor. As display devices are applied to various electronic devices, display devices having various designs are required. For example, the display device may widen a display area for displaying an image by overlapping a camera or a sensor with the display area.

The above information disclosed in this Background section is only for enhancement of understanding of the background and therefore the information discussed in this Background section does not necessarily constitute prior art.

### SUMMARY

The present invention provides a display device capable of improving sensitivity of a camera or sensor overlapping a display area by improving point spread function characteristics of light passing through the display panel. The present invention is defined by the features of the independent claims. The dependent claims describe preferred embodiments.

However, aspects of embodiments according to the present invention are not restricted to those set forth herein. The above and other aspects of the present invention will become more apparent to one of ordinary skill in the art to which the present invention pertains by referencing the detailed description of the present invention given below.

According to an embodiment of the present invention, a display device comprises a first display area comprising a plurality of emission areas emitting light, and a second display area adjacent to the first display area. The second display area comprises a plurality of emission areas, a transmission portion transmitting light, a thin film transistor, especially a plurality of thin film transistor, on a substrate, a pixel defining layer on the thin film transistor(s) to define the plurality of emission areas and including a flat portion having a flat upper surface and a tapered portion having an upper surface inclined from the upper surface of the flat portion, and a pixel electrode on the thin film transistor to be exposed by the pixel defining layer and completely overlapping the tapered portion. Completely overlapping especially means that in a cross section through the substrate the tapered portion of the pixel defining layer is completely covered, directly or indirectly, by the pixel electrode. For example, the tapered portion of the pixel defining layer may be directly disposed on the pixel electrode.

According to some embodiments, the pixel electrode may overlap the edge of the flat portion and may not overlap the transmission portion. This means, in a plane view, the transmission portion may be completely outside of the pixel electrode.

According to some embodiments, the number of pixels per unit area of the second display area may be smaller than the number of pixels per unit area of the first display area.

According to some embodiments, the second display area may further comprise a light emitting layer on the pixel electrode, and a common electrode on the light emitting layer in the plurality of emission areas and on the pixel defining layer in an area excluding the plurality of emission areas and the transmission portion.

According to some embodiments, the second display area may further comprise a first metal layer on the substrate and including a light blocking layer, an active layer on the first metal layer and including a semiconductor region of the thin film transistor, a second metal layer on the active layer and including a gate electrode of the thin film transistor, a third metal layer on the second metal layer and including a capacitor electrode overlapping the gate electrode, a fourth metal layer on the third metal layer and including a first connection electrode connected to the thin film transistor, and a fifth metal layer on the fourth metal layer and including a second connection electrode electrically connecting the first connection electrode and the pixel electrode.

According to some embodiments, the transmission portion may not overlap the first to fifth metal layers, the pixel electrode, and the common electrode. This means, in a plane view, the transmission portion may be completely outside of the first to fifth metal layers, the pixel electrode, and the common electrode.

According to some embodiments, the first display area may further comprise a thin film transistor, especially a plurality of thin film transistor, on a substrate; a pixel defining layer on the thin film transistor(s) to define the plurality of emission areas, a spacer on the pixel defining layer to be between the plurality of emission areas, and a pixel electrode on the thin film transistor. The thin film transistor, especially thin film transistors, of the first display area may also be termed as first area thin film transistor(s). The thin film transistor, especially thin film transistors, of the second display area may also be termed as second area thin film transistor(s). The pixel defining layer on the second area thin film transistor(s) may be the same as the pixel defining layer on the first area thin film transistor(s), that is the pixel defining layer may extend from the first display area into the second display area, especially on a same level.

According to some embodiments, the second display area may further comprise a spacer on the pixel defining layer and between the plurality of emission areas.

According to some embodiments, the second display area may further comprise a light blocking pattern on the same layer as the pixel electrode to completely overlap the spacer.

According to some embodiments, the number of the spacers per unit area of the second display area may be smaller than the number of the spacers per unit area of the first display area.

According to an embodiment of the present invention, a display device comprises a first display area comprising a plurality of emission areas emitting light, and a second display area adjacent to the first display area. The second display area comprises a plurality of emission areas, a transmission portion transmitting light, a first metal layer on a substrate and including a light blocking layer, an active layer on the first metal layer and comprising a semiconductor region of the thin film transistor, a second metal layer on the active layer and comprising a gate electrode of the thin film transistor, a third metal layer on the second metal layer and comprising a capacitor electrode overlapping the gate electrode, a fourth metal layer on the third metal layer and comprising a first connection electrode connected to the thin film transistor, a fifth metal layer on the fourth metal layer and comprising a second connection electrode electrically connected the first connection electrode and the pixel electrode, and a pixel defining layer on the fifth metal layer to define the plurality of emission areas and including a flat portion having a flat upper surface and a tapered portion having an upper surface inclined from the upper surface of the flat portion. The tapered portion of the pixel defining layer overlaps at least one of the first to fifth metal layers.

According to some embodiments, the second connection electrode may completely overlap the tapered portion.

According to some embodiments, the first metal layer may further comprise a first light blocking pattern overlapping a portion of the tapered portion. The third metal layer may further comprise a second light blocking pattern overlapping the other portion of the tapered portion. The first connection electrode may overlap still another portion of the tapered portion.

According to some embodiments, the number of the pixels per unit area of the second display area may be smaller than the number of the pixels per unit area of the first display area.

According to some embodiments, the second display area may further comprise a light emitting layer on the pixel electrode, and a common electrode on the light emitting layer in the plurality of emission areas and on the pixel defining layer in an area excluding the plurality of emission areas and the transmission portion.

According to an embodiment of the present invention, a display device comprises a first display area comprising a plurality of emission areas emitting light, and a second display area comprising the plurality of emission areas and a transmission portion transmitting light. Each of the first and second display areas further comprises a pixel defining layer on a substrate to define the plurality of emission areas, a spacer on the pixel defining layer and between the plurality of emission areas, and a pixel electrode exposed by the pixel defining layer. The second display area further comprises a light blocking pattern on the same layer as the pixel electrode to completely overlap the spacer.

According to some embodiments, the number of the spacers per unit area of the second display area may be smaller than the number of the spacers per unit area of the first display area.

According to some embodiments, the pixel defining layer may comprise a flat portion having a flat upper surface and a tapered portion having an upper surface inclined from the upper surface of the flat portion. The pixel electrode may pass through the tapered portion and may extend to the edge of the flat portion.

According to some embodiments, the second display area may further comprise a light emitting layer on the pixel electrode, and a common electrode on the light emitting layer in the plurality of emission areas and on the pixel defining layer in an area excluding the plurality of emission areas and the transmission portion.

According to some embodiments, the transmission portion may not overlap the pixel electrode and the common electrode.

In a display device according to embodiments of the present invention, by including a metal layer completely overlapping a tapered portion of a pixel defining layer, infrared rays from a camera or sensor incident on the lower surface of the tapered portion may be blocked. The display device may prevent or reduce instances of infrared rays emitted from a camera or sensor passing through the tapered portion, and transmit infrared rays through the transmission portion and the flat portion of the pixel defining layer. Accordingly, the display device may relatively improve point spread function characteristics of light and relatively improve sensitivity of a camera or sensor.

It should be noted that the characteristics of embodiments according to the present invention are not limited to those described above, and other characteristics of embodiments according to the present invention will be apparent from the following description.

### BRIEF DESCRIPTION OF THE DRAWINGS

The above and other aspects and features of embodiments according to the present invention will become more apparent by describing in more detail aspects of some embodiments thereof with reference to the attached drawings, in which:
FIG. 1 is a plan view illustrating a display device according to some embodiments;
FIG. 2 is a block diagram illustrating a display panel and a display driver according to some embodiments;
FIG. 3 is a plan view illustrating a first display area of FIG. 1 according to some embodiments;
FIG. 4 is a cross-sectional view taken along line I-I' of FIG. 3 according to some embodiments;
FIG. 5 is a plan view illustrating an example of a second display area of FIG. 1 according to some embodiments;
FIG. 6 is a cross-sectional view taken along the line II-II' of FIG. 5 according to some embodiments;
FIG. 7 is a diagram illustrating a flat portion and a tapered portion of a pixel defining layer of FIG. 6 according to some embodiments;
FIG. 8 is a diagram illustrating a transmission characteristics and light blocking characteristics of a second display area in a display device according to some embodiments;
FIG. 9 is another example of a cross-sectional view taken along the line II-II' of FIG. 5 according to some embodiments;
FIG. 10 is still another example of a cross-sectional view taken along the line II-II' of FIG. 5 according to some embodiments;
FIG. 11 is a plan view illustrating another example of a second display area of FIG. 1 according to some embodiments; and
FIG. 12 is a cross-sectional view taken along the line III-III' of FIG. 11 according to some embodiments.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the invention disclosed herein. It is apparent, however, that various embodiments may be practiced without these specific details or with one or more equivalent arrangements. In other instances, structures and devices are shown in block diagram form in order to avoid unnecessarily obscuring various embodiments. Further, various embodiments may be different, but do not have to be exclusive nor limit the invention. For example, specific shapes, configurations, and characteristics of some embodiments may be used or implemented in other embodiments without departing from the present invention.

Unless otherwise specified, the illustrated embodiments are to be understood as providing features of varying detail of some ways in which the invention may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When embodiments may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not necessarily intended to be limiting.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the invention. Further, the blocks, units, parts, and/or modules of some embodiments may be physically combined into more complex blocks, units, parts, and/or modules without departing from the scope of the invention.

Unless otherwise defined or implied herein, all terms (including technical and scientific terms) used herein have the same meaning as commonly understood by those skilled in the art to which this invention pertains. It will be further understood that terms, such as those defined in commonly used dictionaries, should be interpreted as having a meaning that is consistent with their meaning in the context of the relevant art and the invention, and should not be interpreted in an ideal or excessively formal sense unless clearly so defined herein.

Hereinafter, detailed embodiments of the invention are described with reference to the accompanying drawings.

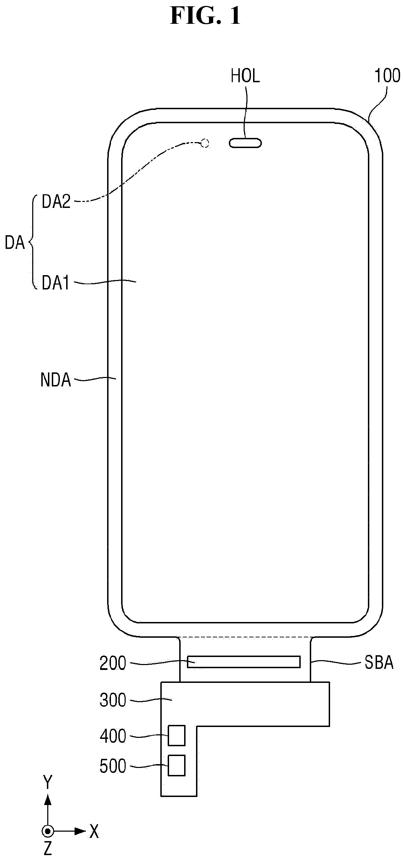

FIG. 1 is a plan view illustrating a display device according to some embodiments.

Referring to FIG. 1, a display device may be applied to portable electronic devices such as mobile phones, smartphones, tablet personal computers (PCs), mobile communication terminals, electronic notebooks, electronic books, portable multimedia players (PMPs), navigation devices, and ultra mobile PCs (UMPCs), or may be applied to wearable devices such as smart watches, and watch phones.

The display device may have a shape similar to a rectangular shape, in a plan view. For example, the display device may have a shape similar to a rectangular shape, in a plan view, having short sides in an X-axis direction and long sides in a Y-axis direction. A corner where the short side in the X-axis direction and long sides in the Y-axis direction meet may be rounded with a curvature (e.g., a set or predetermined curvature) or may be right-angled. The shape of the display device in a plan view is not limited to the rectangular shape, and may be a shape similar to other polygonal shapes, a circular shape, or an elliptical shape. Additionally, according to some embodiments, the display device may have circular or rounded corners or apexes in a plan view.

The display device may include a display panel 100, a display driver 200, a circuit board 300, a touch driver 400, and a power supply unit 500.

The display panel 100 may include a display area DA, a hole HOL, and a non-display area NDA. The display area DA may include pixels displaying an image. The display area DA may emit light from a plurality of emission areas or a plurality of opening areas. For example, the display area DA may include a pixel circuit including switching elements, a pixel defining layer defining an emission area or an opening area, and a self-light emitting element.

For example, the self-light emitting element may include one of an organic light emitting diode (LED) including an organic light emitting layer, a quantum dot LED including a quantum dot light emitting layer, an inorganic LED including an inorganic semiconductor, or a micro LED, but embodiments according to the present invention are not limited thereto.

The display area DA may include a first display area DA1 and a second display area DA2. The first display area DA1 may occupy a significant portion of the display area DA. The first display area DA1 may perform the main purpose of the display device by including a plurality of pixels and displaying a main portion of an image. The second display area DA2 may be located at one edge of the display area DA, but embodiments according to the present invention are not limited thereto. The second display area DA2 may be surrounded by the first display area DA1. The second display area DA2 may include a plurality of pixels and a transmission portion. A plurality of pixels of the second display area DA2 may display images, and the transmission portion of the second display area DA2 may transmit light from a camera or sensor located below the display panel 100. For example, the display device may include at least one of a front camera, a face recognition camera, an infrared camera, a proximity sensor, an illuminance sensor, an iris sensor, or a fingerprint recognition sensor arranged to overlap the second display area DA2 below the display panel 100.

The number of pixels per unit area of the first display area DA1 may be greater than the number of pixels per unit area of the second display area DA2. The first display area DA1 is an area for displaying an image, which is the main purpose of the display device, and pixels may be densely arranged in the first display area DA1. Since the second display area DA2 includes the transmission portion through which light is transmitted, the number of pixels per unit area may decrease as the area of the transmission portion increases.

The hole HOL may be located adjacent to the second display area DA2 at one edge of the display area DA, but is not limited thereto. The hole HOL may be surrounded by the first display area DA1. The hole HOL may relatively improve light transmission efficiency by penetrating at least a portion of the display panel 100. The display device may include at least one of a front camera, a face recognition camera, an infrared camera, a proximity sensor, an illuminance sensor, an iris sensor, or a fingerprint recognition sensor arranged to overlap the hole HOL below the display panel 100. Accordingly, a plurality of cameras or a plurality of sensors may be separately arranged in an area overlapping the second display area DA2 and the hole HOL in the display device.

The non-display area NDA may be arranged around the display area DA. The non-display area NDA may be defined as an edge area of the display panel 100. The non-display area NDA may include a gate driver supplying gate signals to gate lines and fan out lines connecting the display driver 200 and the display area DA.

A sub-region SBA may extend from one side of the non-display area NDA. The sub-region SBA may include a flexible material which can be bent, folded or rolled. For example, when the sub-region SBA is bent, the sub-region SBA may overlap the display area DA in a thickness direction (Z-axis direction). The sub-region SBA may include the display driver 200 and a pad portion connected to the circuit board 300. Alternatively, the sub-region SBA may be omitted, and the display driver 200 and the pad portions may be located in the non-display area NDA.

The display driver 200 may output signals and voltages for driving the display panel 100. The display driver 200 may supply data voltages to data lines. The display driver 200 may supply a source voltage to a power line and supply gate control signals to the gate driver. The display driver 200 may be formed as an integrated circuit (IC) and be mounted on the display panel 100 in a chip on glass (COG) manner, a chip on plastic (COP) manner, or an ultrasonic bonding manner. As an example, the display driver 200 may be located in the sub-region SBA, and may overlap the display area DA in the thickness direction (Z-axis direction) by bending of the sub-region SBA. As another example, the display driver 200 may be mounted on the circuit board 300.

The circuit board 300 may be attached onto the pad portions of the display panel 100 using an anisotropic conductive film (ACF). Lead lines of the circuit board 300 may be electrically connected to the pad portions of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply touch driving signals to a plurality of touch electrodes of the touch sensing unit and sense change amounts in capacitance between the plurality of touch electrodes. For example, the touch driving signal may be a pulse signal having a frequency (e.g., a set or predetermined frequency). The touch driver 400 may decide whether or not an input has been generated and calculate input coordinates, based on the change amounts in capacitance between the plurality of touch electrodes. The touch driver 400 may be formed as an integrated circuit (IC).

The power supply unit 500 may be located on the circuit board 300 to supply a power voltage to the display driver 200 and the display panel 100. The power supply unit 500 may generate a driving voltage to supply it to a driving voltage line, and generate a common voltage to supply it to a common electrode which is common to light emitting elements of the plurality of pixels. For example, the driving voltage may be a high potential voltage for driving the light emitting element, and the common voltage may be a low potential voltage for driving the light emitting element. The power supply unit 500 may generate an initialization voltage to supply it to the initialization voltage line, generate a reference voltage to supply it to the reference voltage line, and generate a bias voltage to supply it to the bias voltage line.

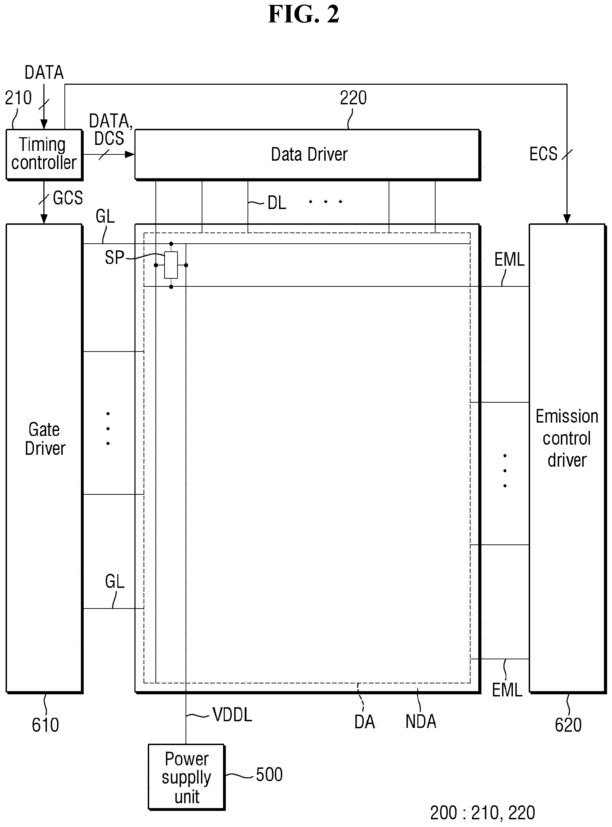

FIG. 2 is a block diagram illustrating a display panel and a display driver according to some embodiments.

Referring to FIG. 2, the display panel 100 may include the display area DA and the non-display area NDA. The display area DA may include pixels SP, a driving voltage line VDDL, a gate line GL, an emission control line EML and a data line DL. Although FIG. 2 illustrates a single pixel SP, a single driving voltage line VDDL, a single gate line GL, a single emission control line EML, and a single data line DL, as a person having ordinary skill in the art would recognize, the display panel 100 may include any suitable number of components according to the design and size of the display panel 100.

Each of the plurality of pixels SP may be connected to the gate line GL, the data line DL, the emission control line EML and the driving voltage line VDDL. Each of the plurality of pixels SP may include at least one of transistor, a light emitting element or a capacitor.

The gate lines GL may extend in the X-axis direction and may be spaced apart from each other in the Y-axis direction that crosses the X-axis direction. The gate lines GL may sequentially supply gate signals to the plurality of pixels SP.

The emission control lines EML may extend in the X-axis direction and may be spaced apart from each other in the Y-axis direction. The emission control lines EML may sequentially supply emission signals to the plurality of pixels SP.

The data lines DL may extend in the Y-axis direction and may be spaced apart from each other in the X-axis direction. The data lines DL may supply the data voltage to the plurality of pixels SP. The data voltage may determine the luminance of each of the pixels SP.

The driving voltage lines VDDL may extend in the Y-axis direction and may be spaced apart from each other in the X-axis direction. The driving voltage lines VDDL may supply a driving voltage to the plurality of pixels SP. The driving voltage may be a high potential voltage for driving the light emitting elements of the pixels SP.

The display driver 200 may include a timing controller 210 and a data driver 220.

The timing controller 210 may receive digital video data DATA and timing signals from the circuit board 300. The timing controller 210 may supply gate control signals GCS to a gate driver 610 and emission control signals ECS to an emission control driver 620. The timing controller 210 may output the digital video data DATA and the data control signal DCS to the data driver 220. The timing controller 210 may generate, based on the timing signals, a data control signal DCS to control the operation timing of the data driver 220, a gate control signal GCS to control the operation timing of the gate driver 610, and an emission control signal ECS to control the operation timing of the emission control driver 620.

The data driver 220 may convert the digital video data DATA into analog data voltages and supply them to the data lines DL through the fan out lines. The gate signals of the gate driver 610 may select pixels SP to which the data voltage is supplied, and the selected pixels SP may receive the data voltage through the data lines DL.

The power supply unit 500 may be located on the circuit board 300 to supply a power voltage to the display driver 200 and the display panel 100. The power supply unit 500 may generate a driving voltage to supply it to a driving voltage line VDDL, and may generate a common voltage to supply it to a common electrode that is common to the light emitting elements of a plurality of pixels SP. The power supply unit 500 may generate an initialization voltage to supply it to the initialization voltage line, generate a reference voltage to supply it to the reference voltage line, and generate a bias voltage to supply it to the bias voltage line.

The gate driver 610 may be located at one external side of the display area DA or at one side of the non-display area NDA. The emission control driver 620 may be located at the other external side of the display area DA or at the other side of the non-display area NDA. However, the present invention is not limited thereto. As another example, the gate driver 610 and the emission control driver 620 may be located at any one of one side and the other side of the non-display area NDA.

The gate driver 610 may include a plurality of transistors for generating gate signals based on the gate control signal GCS. The emission control driver 620 may include a plurality of transistors that generate the emission control signals ECS based on the emission signal. For example, the transistors of the gate driver 610 and the transistors of the emission control driver 620 may be formed on the same layer as the transistors of each of the pixels SP. The gate driver 610 may supply the gate signals to the gate lines GL, and the emission control driver 620 may supply the emission signals to the emission control lines EML.

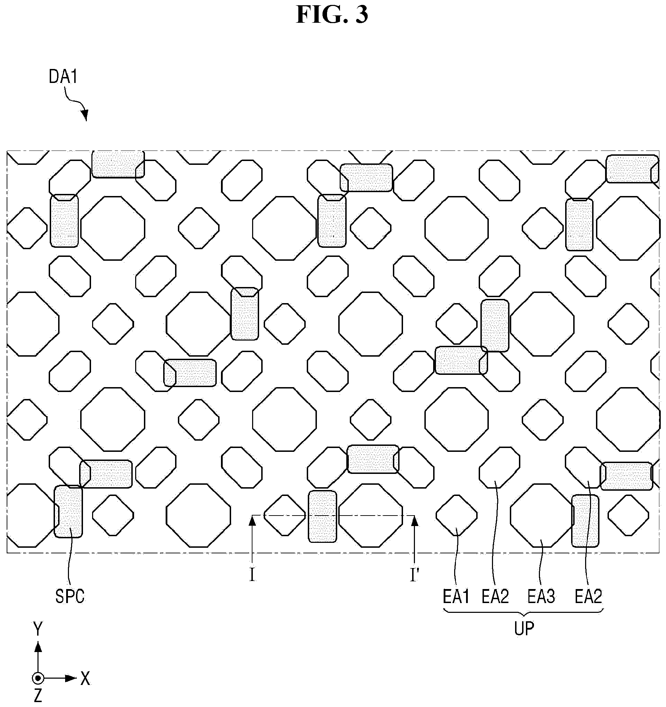

FIG. 3 is a plan view illustrating a first display area of FIG. 1.

Referring to FIG. 3, a first display area DA1 may include first to third emission areas EA1 to EA3 and a spacer SPC. The first to third emission areas EA1 to EA3 may emit light from the light emitting elements of the pixel SP. For example, the first emission area EA1 may emit light of a first color or red light, the second emission area EA2 may emit light of a second color or green light, and the third emission area EA3 may emit light of a third color or blue light, but is not limited thereto.

One pixel group UP may represent white gray scale by including one first emission area EA1, two second emission areas EA2, and one third emission area EA3, but the configuration of the pixel group UP is not limited thereto. The white gray scale may be represented by a combination of light emitted from one first emission area EA1, light emitted from two second emission areas EA2, and light emitted from one third emission area EA3.

The first to third emission areas EA1 to EA3 may be different in size from each other. For example, the size of the third emission area EA3 may be larger than that of the first emission area EA1, and the size of the first emission area EA1 may be larger than that of the second emission area EA2. However, the present invention is not limited thereto. As another example, the sizes of the first to third emission areas EA1 to EA3 may be the same.

For example, the first and third emission areas EA1 and EA3 may be alternately arranged in the same row or column, but are not limited thereto. The first and third emission areas EA1 and EA3 may be adjacent to each other in the X-axis direction or the Y-axis direction. The plurality of second emission areas EA2 may be arranged in rows and columns different from those of the first and third emission areas EA1 and EA3, but are not limited thereto. The plurality of second emission areas EA2 may be adjacent to each other in the X-axis direction or the Y-axis direction.

A plurality of spacers SPC may be located between the first to third emission areas EA1 to EA3. For example, a portion of the spacer SPC may overlap a portion of at least one of the first to third emission areas EA1 to EA3, but embodiments according to the present invention are not limited thereto. The spacer SPC may support a mask during the manufacturing process of the display device and relatively improve reliability by preventing or reducing damage to the light emitting elements.

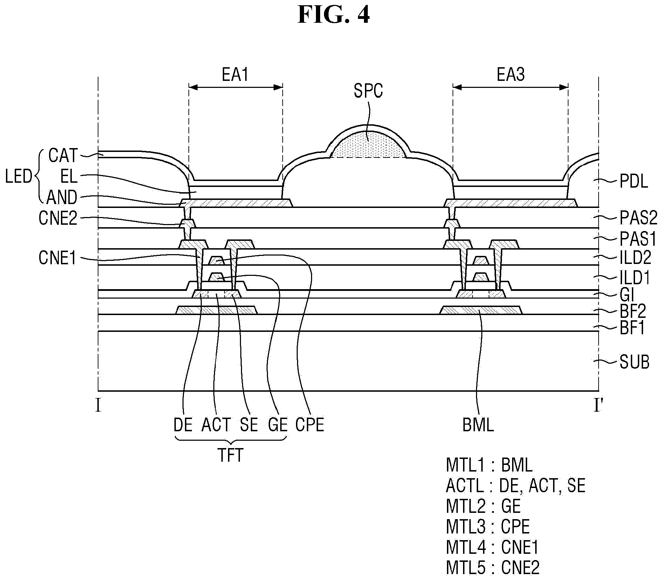

FIG. 4 is a cross-sectional view taken along the line I-I' of FIG. 3.

Referring to FIG. 4, the display panel 100 may include a substrate SUB, a first buffer layer BF1, a first metal layer MTL1, a second buffer layer BF2, an active layer ACTL, a gate insulating layer GI, a second metal layer MTL2, a first interlayer insulating layer ILD1, a third metal layer MTL3, a second interlayer insulating layer ILD2, a fourth metal layer MTL4, a first passivation layer PAS1, a fifth metal layer MTL5, a second passivation layer PAS2, a pixel defining layer PDL, a spacer SPC, and a light emitting element LED.

The substrate SUB may be a base substrate or a base member. The substrate SUB may be a flexible substrate which can be bent, folded or rolled. For example, the substrate SUB may include a polymer resin such as polyimide (PI), but is not limited thereto. For another example, the SUB may include a glass material or a metal material.

The first buffer layer BF1 may be located on the substrate SUB. The first buffer layer BF1 may include an inorganic layer capable of preventing or reducing penetration of air or moisture. For example, the first buffer layer BF1 may include a plurality of inorganic layers alternately stacked.

The first metal layer MTL1 may be located on the first buffer layer BF1. The first metal layer MTL1 may include a light blocking layer BML. The light blocking layer BML may overlap a thin film transistor TFT and block light incident on the thin film transistor TFT. For example, the first metal layer MTL1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. For another example, the first metal layer MTL1 may be an organic layer including a black pigment.

The second buffer layer BF2 may cover the first buffer layer BF1 and the first metal layer MTL1. The second buffer layer BF2 may include an inorganic layer capable of preventing or reducing penetration of air, moisture, or other contaminants. For example, the second buffer layer BF2 may include a plurality of inorganic layers alternately stacked.

The active layer ACTL may be located on the second buffer layer BF2. The active layer ACTL may include a semiconductor region ACT, a source electrode SE, and a drain electrode DE of the thin film transistor TFT. The semiconductor region ACT of the thin film transistor TFT may overlap a gate electrode GE of the thin film transistor TFT in the thickness direction and may be insulated from the gate electrode GE by the gate insulating layer GI. The source electrode SE and the drain electrode DE of the thin film transistor TFT may be provided by making a material of the semiconductor region ACT conductive. The thin film transistor TFT may constitute a pixel circuit of each of the plurality of pixels SP. For example, the thin film transistor TFT may be a switching transistor or a driving transistor of the pixel circuit. The active layer ACTL may overlap the first metal layer MTL1 in the thickness direction.

The gate insulating layer GI may be located on the active layer ACTL and the second buffer layer BF2. The gate insulating layer GI may insulate the second metal layer MTL2 from the active layer ACTL.

The second metal layer MTL2 may be located on the gate insulating layer GI. The second metal layer MTL2 may include the gate electrode GE of the thin film transistor TFT. The gate electrode GE may overlap the semiconductor region ACT with the gate insulating layer GI interposed therebetween.

The first interlayer insulating layer ILD1 may be located on the second metal layer MTL2 and the gate insulating layer GI. The first interlayer insulating layer ILD1 may insulate the second metal layer MTL2 from the third metal layer MTL3.

The third metal layer MTL3 may be located on the first interlayer insulating layer ILD1. The third metal layer MTL3 may include a capacitor electrode CPE. The capacitor electrodes CPE may overlap the gate electrodes GE in the thickness direction. The capacitor electrode CPE and the gate electrode GE may form capacitances.

The second interlayer insulating layer ILD2 may be located on the third metal layer MTL3 and the first interlayer insulating layer ILD1. The second interlayer insulating layer ILD2 may insulate the third metal layer MTL3 from the fourth metal layer MTL4.

The fourth metal layer MTL4 may be located on the second interlayer insulating layer ILD2. The fourth metal layer MTL4 may include a first connection electrode CNE1. The first connection electrode CNE1 may electrically connect the drain electrode DE of the thin film transistor TFT and a second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT.

The first passivation layer PAS1 may be located on the fourth metal layer MTL4 and the second interlayer insulating layer ILD2. The first passivation layer PAS1 may protect the thin film transistor TFT. The first passivation layer PAS1 may insulate the fourth metal layer MTL4 from the fifth metal layer MTL5.

The fifth metal layer MTL5 may be located on the first passivation layer PAS1. The fifth metal layer MTL5 may include the second connection electrode CNE2. The second connection electrode CNE2 may electrically connect the first connection electrode CNE1 and a pixel electrode AND of the light emitting element LED. The second connection electrode CNE2 may be inserted into a contact hole provided in the first passivation layer PAS1 to be in contact with the first connection electrode CNE1.

The second passivation layer PAS2 may be located on the fifth metal layer MTL5 and the first passivation layer PAS1. The second passivation layer PAS2 may insulate the fifth metal layer MTL5 from the pixel electrode AND.

The pixel defining layer PDL may be located on the second passivation layer PAS2. The pixel defining layer PDL may define the first to third emission areas EA1 to EA3. The pixel defining layer PDL may expose top surfaces of the pixel electrodes AND in the first to third emission areas EA1 to EA3. The pixel defining layer PDL may separate and insulate the pixel electrode AND of the respective pixels SP from each other.

The spacer SPC may be located on the pixel defining layer PDL. The spacer SPC may be integrally formed with the pixel defining layer PDL. A plurality of spacers SPC may be located between the first to third emission areas EA1 to EA3. For example, a portion of the spacer SPC may overlap a portion of at least one of the first to third emission areas EA1 to EA3, but embodiments according to the present invention are not limited thereto. The spacer SPC may support a mask during the manufacturing process of the display device and relatively improve reliability by preventing or reducing damage to the light emitting elements.

The light emitting elements LED may be located on the second passivation layer PAS2. Each light emitting element LED of the plurality of pixels SP may include a pixel electrode AND, a light emitting layer EL, and a common electrode CAT.

The pixel electrode AND may be located on the second passivation layer PAS2. The pixel electrode AND may overlap one of the first to third emission areas EA1 to EA3 defined by the pixel defining layer PDL. The pixel electrode AND may be electrically connected to the thin film transistor TFT through the first and second connection electrodes CNE1 and CNE2. Accordingly, the pixel electrode AND may receive a driving current from the pixel circuit of the pixel SP.

The light emitting layer EL may be located on the pixel electrode AND. For example, the light emitting layer EL may be an organic light emitting layer made of an organic material, but is not limited thereto. In the case of employing the organic light emitting layer as the light emitting layer EL, the pixel circuit of the pixel SP applies a voltage (e.g., a set or predetermined voltage) to the pixel electrode AND, and if the common electrode CAT receives a common voltage or a cathode voltage, the holes can move to the light emitting layer EL through the hole transport layer and electrons can move to the light emitting layer EL through the electron transport layer and the holes and the electrons may be combined to produce light to be emitted by the light emitting layer EL.

The common electrode CAT may be arranged on the light emitting layer EL. For example, the common electrode CAT may be made in the form of an electrode common to all of the pixels SP rather than specific to each of the pixels SP. The common electrode CAT may be located on the light emitting layer EL in the first to third emission areas EA1 to EA3, and may be located on the pixel defining layer PDL in an area other than the first to third emission areas EA1 to EA3.

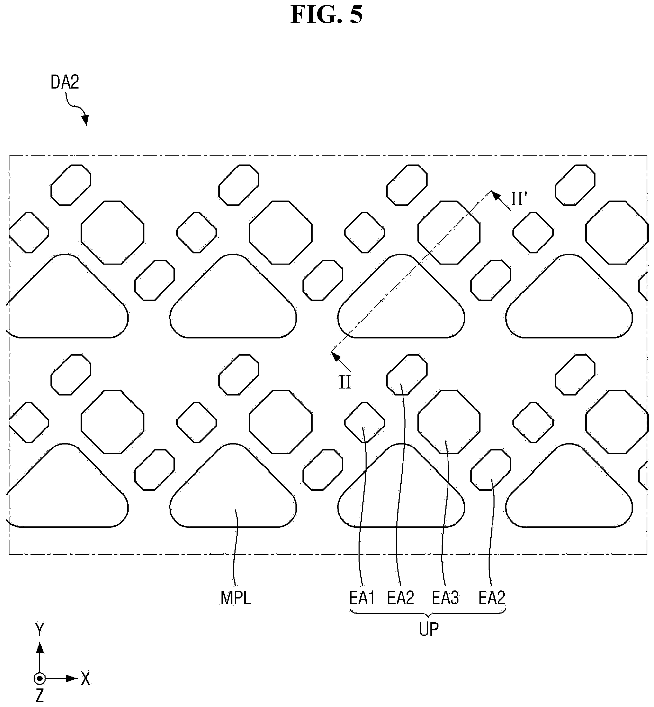

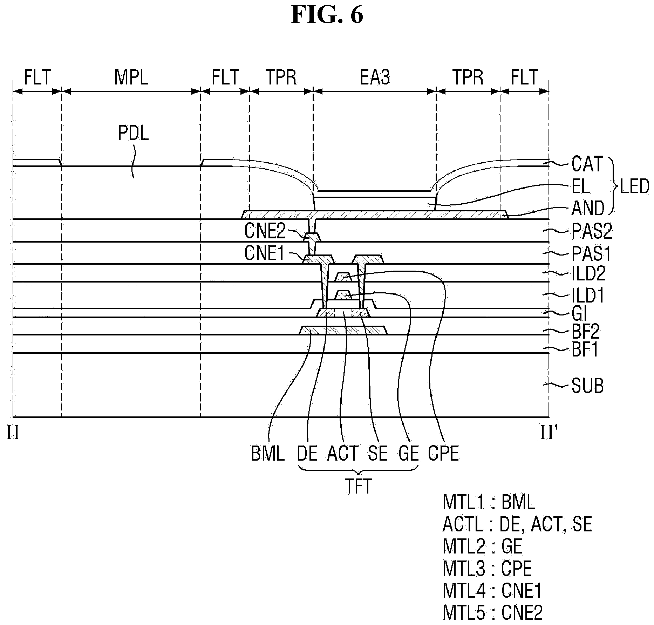

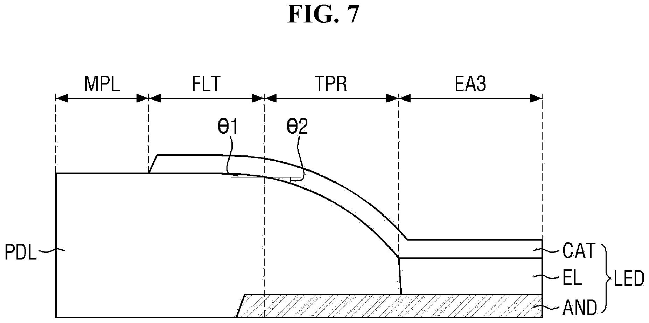

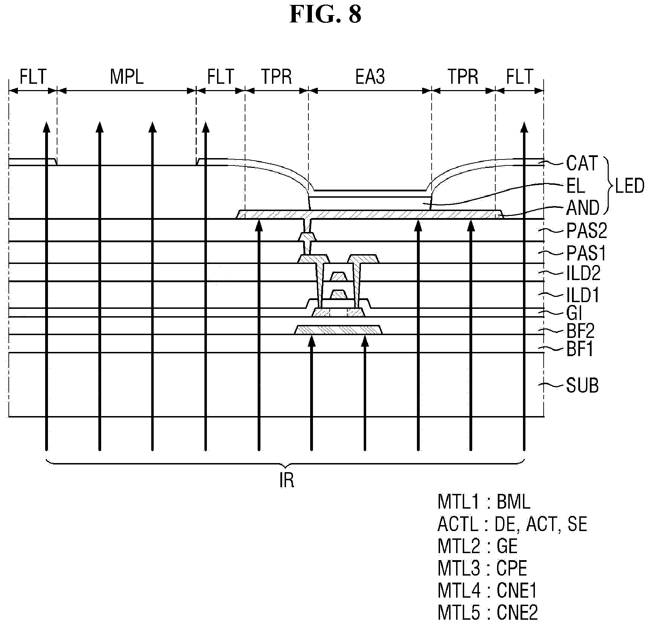

FIG. 5 is a plan view illustrating an example of a second display area of FIG. 1, and FIG. 6 is a cross-sectional view taken along line II-II' of FIG. 5. FIG. 7 is a diagram illustrating a flat portion and a tapered portion of a pixel defining layer of FIG. 6, and FIG. 8 is a diagram illustrating a transmission characteristics and light blocking characteristics of a second display area in a display device according to some embodiments. Hereinafter, the same configuration as the above-described configuration will be briefly described, and some repetitive description thereof may be omitted.

Referring to FIGS. 5 to 8, the second display area DA2 may include first to third emission areas EA1 to EA3 and a transmission portion MPL. The first to third emission areas EA1 to EA3 may emit light from the light emitting elements of the pixel SP. In an area of the first display area DA1 where some of the first to third emission areas EA1 to EA3 are located, the second display area DA2 may include the transmission portion MPL instead. An area of the transmission portion MPL may be larger than the area of each of the first to third emission areas EA1 to EA3. The planar area of FIG. 5 may be substantially the same as the planar area of FIG. 3. Accordingly, the number of pixels SP per unit area of the second display area DA2 may be smaller than the number of pixels SP per unit area of the first display area DA1.

A plurality of transmission portions MPL may be arranged in the same row. The transmission portion MPL may have a triangular shape with rounded corners, but is not limited thereto. The transmission portion MPL may be surrounded by the first to third emission areas EA1 to EA3. For example, the transmission portion MPL may be adjacent to the second and third emission areas EA2 and EA3 in a diagonal direction between the X-axis direction and the Y-axis direction. The transmission portion MPL may be adjacent to the first and second emission areas EA1 and EA2 in a diagonal direction between the Y axis direction and the direction opposite to the X axis direction.

In FIG. 6, the pixel electrode AND may extend from each of the first to third emission areas EA1 to EA3, pass through a tapered portion TPR, and extend to an edge of a flat portion FLT. A portion of the pixel electrode AND may be exposed by the first to third emission areas EA1 to EA3, and another portion of the pixel electrode AND may completely overlap the tapered portion TPR and the edge of the flat portion FLT. The pixel electrode AND may cover the lower surface of the tapered portion TPR. The pixel electrode AND may include a light blocking material. For example, the pixel electrodes AND may include a material such as indium tin oxide (ITO), indium zinc oxide (IZO), or indium tin zinc oxide (ITZO). In another example, the pixel electrodes AND may have a stack structure such as ITO/Ag/ITO/, ITO/Ag/IZO, or ITO/Ag/ITZO/IZO. Accordingly, the pixel electrodes AND may block light incident on the lower surface of the tapered portion TPR.

The transmission portion MPL may be defined by the common electrode CAT. The common electrode CAT may be located on the entire surface of the display panel 100 except for the transmission portion MPL. For example, since a material that hinders the adhesion of the common electrode CAT is provided on the pixel defining layer PDL in an area where the transmission portion MPL is to be formed, the common electrode CAT may not be formed on the transmission portion MPL. However, the formation process of the common electrode CAT is not limited thereto. For another example, the common electrode CAT may not be formed on the transmission portion MPL by using a mask. The transmission portion MPL may not overlap the first to fifth metal layers MTL1 to MTL5, the active layer ACTL, the pixel electrode AND, and the common electrode CAT. Accordingly, the transmission portion MPL may transmit light of the camera or the sensor located below the display panel 100.

In FIG. 7, the pixel defining layer PDL may include a flat portion FLT and a tapered portion TPR. The flat portion FLT may have a substantially flat upper surface. The upper surface of the flat portion FLT may be parallel to a horizontal plane. Here, the horizontal plane may be parallel to the upper surface of the substrate SUB and may be perpendicular to the front of the display device. When the upper surface of the flat portion FLT is inclined from the horizontal plane, the upper surface of the flat portion FLT may be inclined at a first angle θ1 with respect to the horizontal plane. The size of the first angle θ1 may be 3 degrees or less. Accordingly, the upper surface of the flat portion FLT may be parallel to the horizontal plane or may be inclined by 3 degrees or less from the horizontal plane. Like the upper surface of the flat portion FLT, the upper surface of the transmission portion MPL may be parallel to the horizontal plane or may be inclined by 3 degrees or less from the horizontal plane.

An upper surface of the tapered portion TPR may be inclined from an upper surface of the flat portion FLT. An upper surface of the tapered portion TPR may be inclined at a second angle θ2 with respect to the horizontal plane. The size of the second angle θ2 may exceed 3 degrees. Accordingly, the upper surface of the tapered portion TPR may be inclined by more than 3 degrees from the horizontal plane. The tapered portion TPR may be located between the flat portion FLT and one of the first to third emission areas EA1 to EA3. The height of the tapered portion TPR may gradually decrease from the flat portion FLT to one of the first to third emission areas EA1 to EA3. The height of the tapered portion TPR may be relatively high in an area adjacent to the flat portion FLT, and may be relatively low in an area adjacent to the first to third emission areas EA1 to EA3.

In FIG. 8, the pixel electrode AND may block light incident on the lower surface of the tapered portion TPR. For example, when infrared rays IR from a camera or sensor located below the display panel 100 are perpendicularly incident on the display panel 100, a portion of the infrared rays IR may be transmitted through the transmission portion MPL and the flat portion FLT of the pixel defining layer PDL, and other portions of infrared rays IR may be reflected and absorbed by the first to fifth metal layers MTL1 to MTL5 and the pixel electrode AND.

An upper surface of the transmission portion MPL or an upper surface of the flat portion FLT of the pixel defining layer PDL may be parallel to the horizontal plane and perpendicular to an incidence direction of infrared rays IR. Accordingly, when infrared rays IR transmit the upper surface of the transmission portion MPL or the upper surface of the flat portion FLT, infrared rays IR may be emitted in the same direction as the incidence direction.

The upper surface of the tapered portion TPR of the pixel defining layer PDL may be inclined from a horizontal plane. For example, when infrared rays IR pass through the upper surface of the tapered portion TPR, the infrared rays IR may be emitted in a direction different from the incidence direction, and the point spread function (PSF) characteristics may deteriorate. In this case, the sensitivity of the camera or sensor may deteriorate.

The display device may include the pixel electrode AND completely overlapping the tapered portion TPR, so that infrared rays IR from a camera or sensor incident on the lower surface of the tapered portion TPR is blocked. The display device may prevent or reduce instances of infrared rays IR emitted by a camera or sensor passing through the tapered portion TPR and transmit infrared rays IR through the transmission portion MPL and the flat portion FLT. Accordingly, the display device may relatively improve a point spread function (PSF) characteristics of light passing through the display panel 100 and may relatively improve sensitivity of a camera or sensor.

The light blocking layer BML may block light incident on the active layer ACTL of the pixel SP, and at least one of the first to fifth metal layers MTL1 to MTL5 or the pixel electrode AND may block light incident on the first to third emission areas EA1 to EA3.

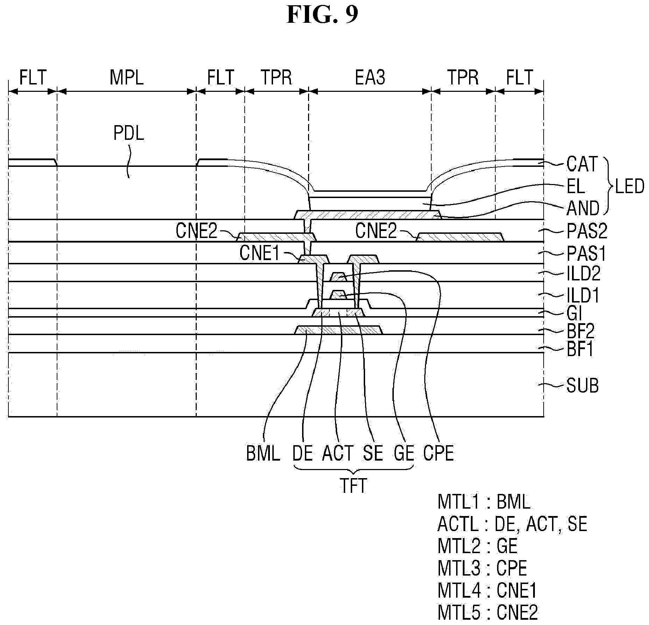

FIG. 9 is another example of a cross-sectional view taken along line II-II' of FIG. 5. The display device illustrated in FIG. 9 is different from the display device illustrated in FIG. 6 in the configuration of the fifth metal layer MTL5. A description of the same configuration as the above-described configuration will be briefly given and some repetitive description may be omitted.

Referring to FIG. 9, the fifth metal layer MTL5 may include a second connection electrode CNE2. The second connection electrode CNE2 may electrically connect the first connection electrode CNE1 and the pixel electrode AND of the light emitting element LED. The second connection electrode CNE2 may pass through the tapered portion TPR and extend to the edge of the flat portion FLT.

The tapered portion TPR may completely overlap one of the first to fifth metal layers MTL1 to MTL5. The second connection electrode CNE2 may completely overlap the tapered portion TPR and may overlap the edge of the flat portion FLT. For example, the fifth metal layer MTL5 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. Accordingly, the fifth metal layer MTL5 may block light incident on the lower surface of the tapered portion TPR.

The display device may include the second connection electrode CNE2 completely overlapping the tapered portion TPR, so that infrared rays IR from a camera or sensor incident on the lower surface of the tapered portion TPR is blocked. The display device may prevent or reduce instances of infrared rays IR emitted by a camera or sensor passing through the tapered portion TPR and transmit infrared rays IR through the transmission portion MPL and the flat portion FLT. Accordingly, the display device may relatively improve a point spread function (PSF) characteristics of light passing through the display panel 100 and may relatively improve sensitivity of a camera or sensor.

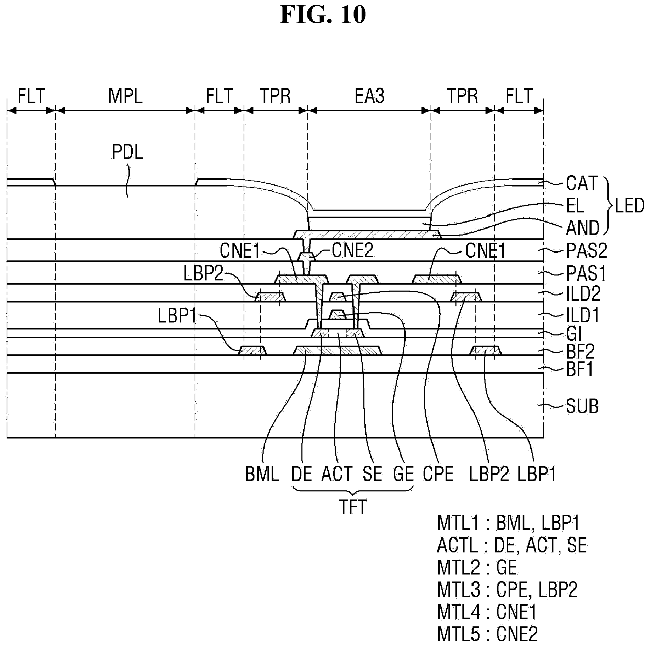

FIG. 10 is still another example of a cross-sectional view taken along line II-II' of FIG. 5. The display device illustrated in FIG. 10 is different from the display device illustrated in FIG. 6 in the configurations of the first metal layer MTL1, the third metal layer MTL3 and the fourth metal layer MTL4. A description of the same configuration as the above-described configuration will be briefly given and some repetitive description may be omitted.

Referring to FIG. 10, a first metal layer MTL1 may be located on a first buffer layer BF1. The first metal layer MTL1 may include a light blocking layer BML and a first light blocking pattern LBP1. The light blocking layer BML may overlap the thin film transistor TFT and block light incident on the thin film transistor TFT.

The third metal layer MTL3 may be located on the first interlayer insulating layer ILD1. The third metal layer MTL3 may include a capacitor electrode CPE and a second light blocking pattern LBP2. The capacitor electrode CPE and the gate electrode GE may form capacitances.

The fourth metal layer MTL4 may be located on the second interlayer insulating layer ILD2. The fourth metal layer MTL4 may include the first connection electrode CNE1. The first connection electrode CNE1 may electrically connect the drain electrode DE of the thin film transistor TFT and the second connection electrode CNE2.

The tapered portion TPR may completely overlap at least one of the first to fifth metal layers MTL1 to MTL5. The first light blocking pattern LBP1 may overlap a portion of the tapered portion TPR, the second light blocking pattern LBP2 may overlap another portion of the tapered portion TPR, and the first connection electrode CNE1 may overlap still another portion of the tapered portion TPR. Accordingly, the first light blocking pattern LBP1, the second light blocking pattern LBP2 and the first connection electrode CNE1 may completely overlap the tapered portion TPR. For example, each of the first to fifth metal layers MTL1 to MTL5 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. Accordingly, the first light blocking pattern LBP1, the second light blocking pattern LBP2 and the first connection electrode CNE1 may block light incident on the lower surface of the tapered portion TPR.

The display device may include the first light blocking pattern LBP1, the second light blocking pattern LBP2, and the first connection electrode CNE1 completely overlapping the tapered portion TPR, so that infrared rays IR from a camera or sensor incident on the lower surface of the tapered portion TPR is blocked. The display device may prevent or reduce instances of infrared rays IR emitted by a camera or sensor passing through the tapered portion TPR and transmit infrared rays IR through the transmission portion MPL and the flat portion FLT. Accordingly, the display device may relatively improve a point spread function (PSF) characteristics of light passing through the display panel 100 and may relatively improve sensitivity of a camera or sensor.

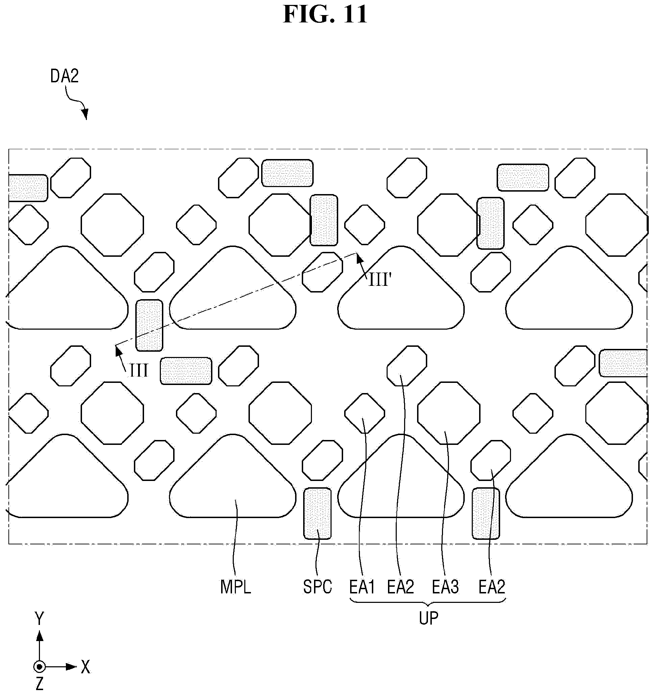

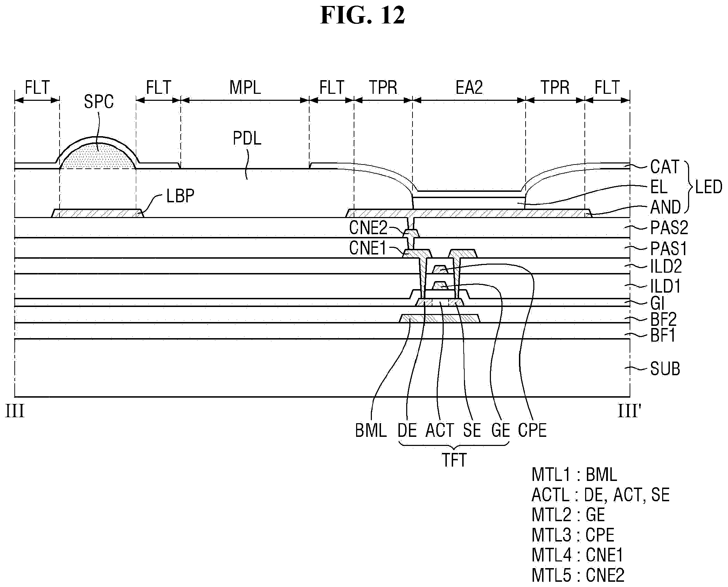

FIG. 11 is a plan view illustrating another example of a second display area of FIG. 1, and FIG. 12 is a cross-sectional view taken along line III-III' of FIG. 11. The display device illustrated in FIG. 11 is substantially identical to the display device of FIG. 6 except that the former further includes a spacer SPC. Therefore, a description of the same configuration as the above-described configuration will be briefly given and some repetitive description may be omitted.

Referring to FIGS. 11 and 12, the second display area DA2 may include first to third emission areas EA1 to EA3, a transmission portion MPL, and a spacer SPC. The first to third emission areas EA1 to EA3 may emit light from the light emitting elements of the pixel SP. In an area of the first display area DA1 where some of the first to third emission areas EA1 to EA3 are located, the second display area DA2 may include the transmission portion MPL instead. An area of the transmission portion MPL may be larger than the area of each of the first to third emission areas EA1 to EA3. The planar area of FIG. 11 may be substantially the same as the planar area of FIG. 3. Accordingly, the number of pixels SP per unit area of the second display area DA2 may be smaller than the number of pixels SP per unit area of the first display area DA1.

A plurality of transmission portions MPL may be arranged in the same row. The transmission portion MPL may have a triangular shape with rounded corners, but is not limited thereto. The transmission portion MPL may be surrounded by the first to third emission areas EA1 to EA3. For example, the transmission portion MPL may be adjacent to the second and third emission areas EA2 and EA3 in a diagonal direction between the X-axis direction and the Y-axis direction. The transmission portion MPL may be adjacent to the first and second emission areas EA1 and EA2 in a diagonal direction between the Y-axis direction and the direction opposite to the X-axis direction.

The plurality of spacers SPC may be located between the first to third emission areas EA1 to EA3 and the transmission portion MPL. For example, a portion of the spacer SPC may overlap a portion of at least one of the first to third emission areas EA1 to EA3, but embodiments according to the present invention are not limited thereto. The spacer SPC may not overlap the transmission portion MPL. The spacer SPC may support a mask during the manufacturing process of the display device and relatively improve reliability by preventing or reducing damage to the light emitting elements. Accordingly, the number of spacers SPC per unit area of the second display area DA2 may be smaller than the number of spacers SPC per unit area of the first display area DA1.

The display device may further include a light blocking pattern LBP completely overlapping the spacer SPC. The light blocking pattern LBP may be located on the same layer as the pixel electrode AND. For example, the light blocking pattern LBP and the pixel electrodes AND may include a material such as indium tin oxide (ITO), indium zinc oxide (IZO), or indium tin zinc oxide (ITZO). In another example, the light blocking pattern LBP may have a stack structure such as ITO/Ag/ITO/, ITO/Ag/IZO, or ITO/Ag/ITZO/IZO. Therefore, the light blocking pattern LBP may block light incident on the lower surface of the tapered portion TPR.

According to some embodiments, the light blocking pattern LBP may be located on at least one of the first to fifth metal layers MTL1 to MTL5.

The light blocking pattern LBP may block light incident on the lower surface of the spacer SPC. For example, when infrared rays IR from a camera or sensor located below the display panel 100 are perpendicularly incident on the display panel 100, a portion of the infrared rays IR may be transmitted through the transmission portion MPL and the flat portion FLT of the pixel defining layer PDL, and other portions of infrared rays IR may be reflected and absorbed by the first to fifth metal layers MTL1 to MTL5, the pixel electrode AND and the light blocking pattern LBP.

The upper surface of the spacer SPC may be inclined from a horizontal plane. For example, when infrared rays IR pass through the upper surface of the spacer SPC, the infrared rays IR may be emitted in a direction different from the incidence direction, and the point spread function (PSF) characteristics may deteriorate. In this case, the sensitivity of the camera or sensor may deteriorate.

The display device may include the light blocking pattern LBP completely overlapping the spacer SPC, so that infrared rays IR from a camera or sensor incident on the lower surface of the spacer SPC is blocked. The display device may prevent or reduce instances of infrared rays IR emitted by a camera or sensor passing through the spacer SPC and transmit infrared rays IR through the transmission portion TPR and the flat portion FLT. Accordingly, the display device may relatively improve a point spread function (PSF) characteristics of light passing through the display panel 100 and may relatively improve sensitivity of a camera or sensor.

In the above, description has been made with reference to aspects of some embodiments of the present invention, but those skilled in the art or those of ordinary skill in the relevant technical field may understand that various modifications and changes may be made to embodiments according to the present invention.

## Claims

1. A display device comprising:
a first display area (DA1) comprising a plurality of emission areas (EA1-EA3) configured to emit light; and
a second display area (DA2) adjacent to the first display area (DA1),
wherein the second display area (DA2) comprises:
a plurality of emission areas (EA1-EA3);
a transmission portion (MPL) configured to transmit light;
a thin film transistor (TFT) on a substrate (SUB);
a pixel defining layer (PDL) on the thin film transistor (TFT) to define the plurality of emission areas (EA1-EA3) and including a flat portion (FLT) having a flat upper surface and a tapered portion (TPR) having an upper surface inclined from the upper surface of the flat portion (FLT); and
a pixel electrode (AND) on the thin film transistor (TFT) to be exposed by the pixel defining layer (PDL) and completely overlapping the tapered portion (TPR).

2. The display device of claim 1,
wherein the pixel electrode (AND) overlaps an edge of the flat portion (FLT) and does not overlap the transmission portion (MPL).

3. The display device of claim 1 or 2,
wherein the second display area (DA2) further comprises:
a first metal layer (MTL1) on the substrate (SUB) and including a light blocking layer (BML);
an active layer (ACTL) on the first metal layer (MTL1) and including a semiconductor region (ACT) of the thin film transistor (TFT);
a second metal layer (MTL2) on the active layer (ACTL) and including a gate electrode (GE) of the thin film transistor (TFT);
a third metal layer (MTL3) on the second metal layer (MTL2) and including a capacitor electrode (CPE) overlapping the gate electrode (GE);
a fourth metal layer (MTL4) on the third metal layer (MTL3) and including a first connection electrode (CNE1) connected to the thin film transistor (TFT); and
a fifth metal layer (MTL5) on the fourth metal layer (MTL4) and including a second connection electrode (CNE2) electrically connecting the first connection electrode (CNE1) and the pixel electrode (AND).

4. The display device of claim 3,
wherein the transmission portion (MPL) does not overlap the first to fifth metal layers (MTL1-MTL5), the pixel electrode (AND), and the common electrode (CAT).

5. The display device of at least one of claims 1 to 4,
wherein the first display area (DA1) further comprises:
a thin film transistor (TFT) on a substrate (SUB);
a pixel defining layer (PDL) on the thin film transistor (TFT) to define the plurality of emission areas (EA1-EA3);
a spacer (SPC) on the pixel defining layer (PDL) and between the plurality of emission areas (EA1-EA3); and
a pixel electrode (AND) on the thin film transistor (TFT).

6. The display device of at least one of claims 1 to 5,
wherein the second display area (DA2) further comprises a spacer (SPC) on the pixel defining layer (PDL) and between the plurality of emission areas (EA1-EA3).

7. The display device of claim 6,
wherein the second display area (DA2) further comprises a light blocking pattern (LBP) on a same layer as the pixel electrode (AND) to completely overlap the spacer (SPC).

8. A display device comprising:
a first display area (DA1) comprising a plurality of emission areas (EA1-EA3) configured to emit light; and
a second display area (DA2) adjacent to the first display area (DA1),
wherein the second display area (DA2) comprises:
a plurality of emission areas (EA1-EA3);
a transmission portion (MPL) configured to transmit light;
a first metal layer (MTL1) on a substrate (SUB) and including a light blocking layer (BML);
an active layer (ACTL) on the first metal layer (MTL1) and comprising a semiconductor region (ACT) of a thin film transistor (TFT);
a second metal layer (MTL2) on the active layer (ACTL) and comprising a gate electrode (GE) of the thin film transistor (TFT);
a third metal layer (MTL3) on the second metal layer (MTL2) and comprising a capacitor electrode (CPE) overlapping the gate electrode (GE);
a fourth metal layer (MTL4) on the third metal layer (MTL3) and comprising a first connection electrode (CNE1) connected to the thin film transistor (TFT);
a fifth metal layer (MTL5) on the fourth metal layer (MTL4) and comprising a second connection electrode (CNE2) electrically connected the first connection electrode (CNE1) and a pixel electrode (AND); and
a pixel defining layer (PDL) on the fifth metal layer (MTL5) to define the plurality of emission areas (EA1-EA3) and including a flat portion (FLT) having a flat upper surface and a tapered portion (TPR) having an upper surface inclined from the upper surface of the flat portion (FLT),
wherein the tapered portion (TPR) of the pixel defining layer (PDL) overlaps at least one of the first to fifth metal layers (MTL1-MTL5).

9. The display device of claim 8,
wherein the second connection electrode (CNE2) completely overlaps the tapered portion (TPR).

10. The display device of claim 8 or 9,
wherein the first metal layer (MTL1) further comprises a first light blocking pattern (LBP1) overlapping a first portion of the tapered portion (TPR),
wherein the third metal layer (MTL3) further comprises a second light blocking pattern (LBP2) overlapping a second portion of the tapered portion (TPR), and
wherein the first connection electrode (CNE1) overlaps a third portion of the tapered portion (TPR).

11. A display device comprising:
a first display area (DA1) comprising a plurality of emission areas (EA1-EA3) configured to emit light; and
a second display area (DA2) comprising the plurality of emission areas (EA1-EA3) and a transmission portion (MPL) configured to transmit light,
wherein each of the first and second display areas (DA1, DA2) further comprises:
a pixel defining layer (PDL) on a substrate (SUB) to define the plurality of emission areas (EA1-EA3);
a spacer (SPC) on the pixel defining layer (PDL) and between the plurality of emission areas (EA1-EA3); and
a pixel electrode (AND) exposed by the pixel defining layer (PDL),
wherein the second display area (DA2) further comprises a light blocking pattern (LBP) on a same layer as the pixel electrode (AND) to completely overlap the spacer (SPC).

12. The display device of claim 11,
wherein the pixel defining layer (PDL) comprises a flat portion (FLT) having a flat upper surface and a tapered portion (TPR) having an upper surface inclined from the upper surface of the flat portion (FLT), and
wherein the pixel electrode (AND) pass through the tapered portion (TPR) and extend to an edge of the flat portion (FLT).

13. The display device of claim 5 and one of claims 6 or 7, or the display device of claim 11 or 12,
wherein a number of spacers (SPC) per unit area of the second display area (DA2) is smaller than a number of spacers (SPC) per unit area of the first display area (DA1).

14. The display device of at least one of claims 1 to 13,
wherein the second display area (DA2) further comprises:
a light emitting layer (EL) on the pixel electrode (AND); and
a common electrode (CAT) on the light emitting layer (EL) in the plurality of emission areas (EA1-EA3) and on the pixel defining layer (PDL) in an area excluding the plurality of emission areas (EA1-EA3) and the transmission portion (MPL).

15. The display device of claim 14,
wherein the transmission portion (MPL) does not overlap the pixel electrode (AND) and the common electrode (CAT).

16. The display device of at least one of claims 1 to 15,
wherein a number of pixels (SP) per unit area of the second display area (DA2) is smaller than a number of pixels (SP) per unit area of the first display area (DA1).
